# EUROPEAN PATENT APPLICATION

(11) **EP 4 765 779 A1**
(43) Date of publication of application: **24.06.2026**
(21) Application number: 25738837.1
(22) Date of filing: 08.01.2025
(51) Int. Cl.: H04L 67/12, G01R 31/396, G01R 31/385, H04L 69/18, H04L 69/16, H04L 67/06, H04L 69/08, G06T 7/00, G06T 7/62

(54) **DATA MANAGEMENT SYSTEM AND DATA MANAGEMENT METHOD**

(30) Priority: 08.01.2024 KR 20240003047
(71) Applicant: LG Energy Solution, Ltd., Seoul 07335 (KR)
(72) Inventor: PARK, Jae Mo, Daejeon 34122 (KR); SHIN, Joon Sik, Daejeon 34122 (KR); LEE, Seung Jun, Daejeon 34122 (KR); KIM, Hyeon Ki, Daejeon 34122 (KR); KIM, Han Jun, Daejeon 34122 (KR); YANG, Dong Hyeon, Daejeon 34122 (KR)
(74) Representative: Goddar, Heinz J.
(86) International application number: PCT/KR2025/000381
(87) International publication number: WO 2025/150870

(57) **Abstract**

According to some embodiments, a data management system includes a first inspection device configured to generate a first inspection image and a first inspection value related to a result of a first manufacturing process of a battery cell, a second inspection device configured to generate a second inspection image and a second inspection value related to a result of a second manufacturing process of the battery cell, a collation device configured to receive the first inspection image, the first inspection value, the second inspection image, and the second inspection value using a plurality of communication schemes, and a management server configured to record the first inspection image and the second inspection image transmitted from the collation device separately from the first inspection value and the second inspection value transmitted from the collation device.

## Description

### CROSS-REFERENCE TO RELATED APPLICATION

The present application claims the benefit of the priority of Korean Patent Application No. 10-2024-0003047, filed on January 8, 2024, which is hereby incorporated by reference in its entirety.

### TECHNICAL FIELD

Embodiments disclosed in this document relate to a data management system and a data management method.

### BACKGROUND ART

Recently, research and development on secondary batteries have been actively conducted. Here, secondary batteries are batteries that can be charged and discharged, and may be interpreted as including both conventional Ni/Cd batteries, Ni/MH batteries, and recent lithium ion batteries. Among secondary batteries, lithium ion batteries have much higher energy density than conventional Ni/Cd batteries, Ni/MH batteries, etc., and may be manufactured to be small and lightweight, and thus lithium ion batteries may have high usability as a power source for mobile devices. Recently, the scope of use of the lithium ion batteries has expanded to include a power source for electric vehicles, and the lithium ion batteries are attracting attention as a next-generation energy storage medium.

In a process of manufacturing a cylindrical battery cell, various inspection devices may be utilized to inspect the results of detailed processes. The inspection devices may generate data such as images and measurement values for inspecting process results and transmit the data to an upper server PC. However, when a large number of inspection devices transmit inspection result data within a short period of time, a situation where some data is omitted due to high transmission load may occur.

### DISCLOSURE OF THE INVENTION

### TECHNICAL PROBLEM

One objective of embodiments disclosed in this document is to provide a data management system and a data management method capable of managing data transmitted by a large number of inspection devices in a cell manufacturing process without omission.

The technical objectives of the embodiments disclosed in this document are not limited to the technical problems mentioned above, and other technical problems not mentioned may be clearly understood by those skilled in the art from the descriptions below.

### TECHNICAL SOLUTION

According to some embodiments, a data management system includes a first inspection device configured to generate a first inspection image and a first inspection value related to a result of a first manufacturing process of a battery cell, a second inspection device configured to generate a second inspection image and a second inspection value related to a result of a second manufacturing process of the battery cell, a collation device configured to receive the first inspection image, the first inspection value, the second inspection image, and the second inspection value using a plurality of communication schemes, and a management server configured to record the first inspection image and the second inspection image transmitted from the collation device separately from the first inspection value and the second inspection value transmitted from the collation device.

According to some embodiments, the plurality of communication schemes include a first communication scheme for receiving the first inspection value, a second communication scheme for receiving the first inspection image, and a third communication scheme for receiving the second inspection image and the second inspection value.

According to some embodiments, the first communication scheme includes a TCP/IP communication scheme, the second communication scheme includes an FTP communication scheme, and the third communication scheme includes an SMB communication scheme.

According to some embodiments, the first inspection device is configured to analyze the first inspection image to extract the first inspection value having a first data format, the second inspection device is configured to analyze the second inspection image to extract the second inspection value having a second data format, and the second data format has a capacity than the capacity of the first data format and a readability higher than the readability of the first data format.

According to some embodiments, the first data format includes a CSV format, and the second data format includes a JSON format.

According to some embodiments, the collation device is configured to convert a data format of the first inspection value from the first data format to the second data format, and transmit the second inspection value and the first inspection value converted into the second data format to the management server.

According to some embodiments, the battery cell includes a cylindrical battery cell, one of the first manufacturing process and the second manufacturing process includes a process of forming an electrode assembly of the cylindrical battery cell, and the other of the first manufacturing process and the second manufacturing process includes a process of sealing the cylindrical electrode assembly in a cylindrical can to form the cylindrical battery cell.

According to some embodiments, the first inspection image includes an image of one of the electrode assembly and the cylindrical can, the second inspection image includes an image of the other of the electrode assembly and the cylindrical can, the first inspection value includes dimensional values of the electrode assembly, and the second inspection value includes dimensional values of the cylindrical can.

According to some embodiments, a data inspection method includes generating, through a first inspection device, a first inspection image and a first inspection value related to a result of a first manufacturing process of a battery cell, generating, through a second inspection device, a second inspection image and a second inspection value related to a result of a second manufacturing process of the battery cell, receiving, through a collating device, the first inspection image, the first inspection value, the second inspection image, and the second inspection value using a plurality of communication schemes, and recording, through a management server, the first inspection image and the second inspection image transmitted from the collation device separately from the first inspection value and the second inspection value transmitted from the collation device.

According to some embodiments, the plurality of communication schemes include a first communication scheme for receiving the first inspection value, a second communication scheme for receiving the first inspection image, and a third communication scheme for receiving the second inspection image and the second inspection value.

According to some embodiments, the first communication scheme includes a TCP/IP communication scheme, the second communication scheme includes an FTP communication scheme, and the third communication scheme includes an SMB communication scheme.

According to some embodiments, the generating of the first inspection value includes analyzing the first inspection image to extract the first inspection value having a first data format, the generating of the second inspection value includes analyzing the second inspection image to extract the second inspection value having a second data format, and the second data format has a capacity greater than the capacity of the first data format and a readability higher than the readability of the first data format.

According to some embodiments, the first data format includes a CSV format, and the second data format includes a JSON format.

According to some embodiments, the data management method further includes converting, through the collation device, a data format of the first inspection value from the first data format to the second data format, and transmitting, through the collation device, the second inspection value and the first inspection value converted into the second data format to the management server.

According to some embodiments, the battery cell includes a cylindrical battery cell, one of the first manufacturing process and the second manufacturing process includes a process of forming an electrode assembly of the cylindrical battery cell, and the other of the first manufacturing process and the second manufacturing process includes a process of sealing the cylindrical electrode assembly in a cylindrical can to form the cylindrical battery cell.

According to some embodiments, the first inspection image includes an image of one of the electrode assembly and the cylindrical can, the second inspection image includes an image of the other of the electrode assembly and the cylindrical can, and the first inspection value includes dimensional values of the electrode assembly, and the second inspection value includes dimensional values of the cylindrical can.

### ADVANTAGEOUS EFFECTS

According to the embodiments disclosed in this document, a data management system and a data management method capable of managing data transmitted by multiple inspection devices in a cell manufacturing process without omission may be provided.

The technical effects according to the embodiments disclosed in this document are not limited to the effects mentioned above, and other effects not mentioned may be clearly understood by those skilled in the art according to the disclosure of this document.

### BRIEF DESCRIPTION OF THE DRAWINGS

FIG. 1 illustrates a data collection system in a manufacturing process of a battery cell according to some embodiments.
FIG. 2 illustrates elements constituting a data management system according to some embodiments.
FIG. 3 illustrates a data management method in a manufacturing process of a battery cell according to a prior art.
FIG. 4 illustrates communication schemes for collecting inspection data according to some embodiments.
FIG. 5 illustrates a method for recording inspection data collected through communication schemes according to some embodiments.
FIG. 6 illustrates steps constituting a data management method according to some embodiments.

### MODE FOR CARRYING OUT THE INVENTION

Hereinafter, embodiments described in this document are described with reference to the accompanying drawings. However, this is not intended to limit the disclosure of this document to a specific embodiment, but should be understood to include various modifications, equivalents, and/or alternatives of the embodiments described in this document.

Embodiments of this document and the terms used herein are not intended to limit the technical features described in this document to a specific embodiment, but should be understood to include various modifications, equivalents, or alternatives of the corresponding embodiment. In connection with the description of the drawings, similar reference numerals may be used for similar or related components. The singular form of a noun corresponding to an item may include one or more of said items, unless the context clearly indicates otherwise.

In this document, each of phrases "A or B", "at least one of A and B", "at least one of A or B", "A, B, or C", "at least one of A, B, and C", and "at least one of A, B, or C" may include any one of the items listed together in that phrase, or all possible combinations thereof. Terms such as "first", "second", "firstly", "secondly", "A", "B", "(a)", or "(b)" may be used merely to distinguish one component from another, and do not limit the components in any other respect (e.g., importance or order) unless specifically stated otherwise.

In this document, when a component (e.g., a first component) is referred to as being "connected", "coupled" or "joined" to another component (e.g., a second component), with or without the terms "functionally" or "communicatively", it means that the component may be connected to the other component directly (e.g., in a wired manner or wirelessly), or indirectly (through a third component).

A method according to various embodiments disclosed in this document may be provided by being included in a computer program product. The computer program product may be traded between a seller and a buyer as a product. The computer program product may be distributed in the form of a machine-readable storage medium (e.g., compact disc read only memory (CD-ROM)), or may be distributed online (e.g., downloaded or uploaded) through an application store or directly between two user devices. In the case of online distribution, at least a part of the computer program product may be temporarily stored or temporarily generated in a machine-readable storage medium such as a memory of a manufacturer's server, an application store's server, a relay server.

According to the embodiments disclosed in this document, each of the components (e.g., modules or programs) described above may include a single or plurality of entities, and some of the plurality of entities may be separated and placed in other components. According to the embodiments disclosed in this document, one or more of the components or operations described above may be omitted, or one or more other components or operations may be added. Alternatively or additionally, a plurality of components (e.g., modules or programs) may be integrated into a single component. In such a case, the integrated component may perform one or more functions of each of the plurality of components identically or similarly to those performed by the corresponding component among the plurality of components prior to the integration. According to the embodiments disclosed in this document, the operations performed by a module, program, or other component may be performed sequentially, in parallel, repeatedly, or heuristically, or one or more of the operations may be performed in a different order, omitted, or performed by being added with one or more other operations.

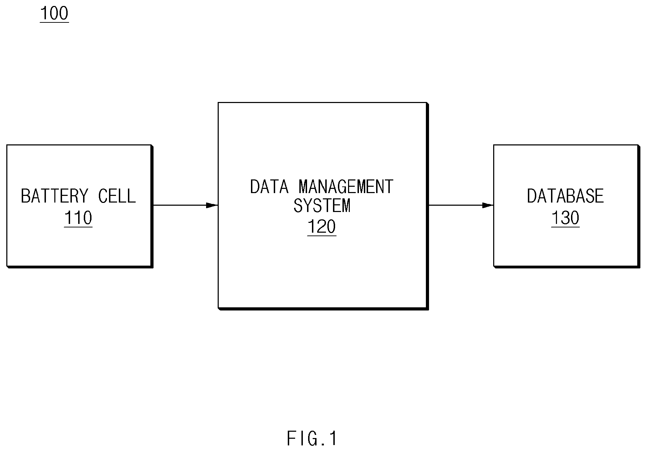

FIG. 1 illustrates a data collection system in a manufacturing process of a battery cell according to some embodiments.

Referring to FIG. 1, the data collection system 100 may collect inspection data used for inspection of a battery cell 110 in a manufacturing process of a battery cell 110 into a database 130.

The battery cell 110 may include a cylindrical battery cell. The battery cell 110 may be manufactured through detailed manufacturing processes. In order to determine whether each detailed manufacturing process is performed normally, a data management system 120 may generate inspection data. The inspection data may be recorded in the database 130.

When inspection data is generated and managed in the manufacturing process of the battery cell 110, a problem in which some data is omitted due to excessive data transmission traffic may occur. For example, when inspection images and inspection values are generated for a plurality of battery cells, high-capacity images may be transmitted to a single intermediate management device within a short period of time. In this case, the communication capacity may exceed its limit, which may result in some data being omitted.

In order to solve this problem, the data management system 120 may prevent excessive data traffic from occurring by applying different communication schemes for each type of data collection device and each type of data being collected, and thus prevent some of the inspection data from being omitted.

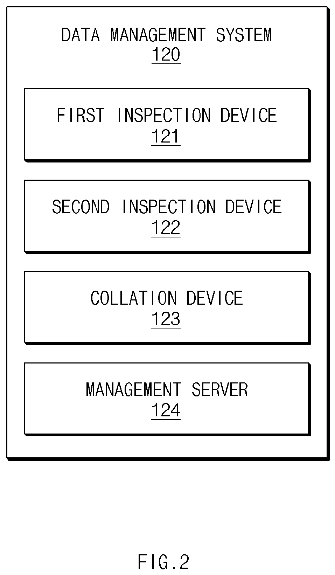

FIG. 2 illustrates elements constituting a data management system according to some embodiments.

Referring to FIG. 2, the data management system 120 may include a first inspection device 121, a second inspection device 122, a collation device 123, and a management server 124. However, the present invention is not limited thereto, and some configurations may be omitted from the data management system 120, or other general-purpose configurations may be further included in the data management system 120.

A first inspection device 121 and a second inspection device 122 may collect inspection data to determine whether the detailed manufacturing processes of the battery cell 110 have been appropriately performed. The inspection data may include image data obtained by photographing a process result of each detailed manufacturing process. To this end, the first inspection device 121 and the second inspection device 122 may include a photographing means such as a camera, an image sensor, etc.

According to the embodiment, the detailed manufacturing processes of the battery cell 110 may include a process of manufacturing a battery electrode assembly, a process of sealing the electrode assembly in a battery can, etc. The first inspection device 121 and the second inspection device 122 may photograph the electrode assembly, the battery can, etc. as process results.

According to the embodiment, the first inspection device 121 may include any one of a standalone vision inspection device and a PC vision inspection device, and the second inspection device 122 may include the other of the standalone vision inspection device and the PC vision inspection device. The standalone vision inspection device may include a separate controller on its own, and through this, may independently perform image capture and data transmission, etc. The PC vision inspection device may process inspection data based on a PC. The first inspection device 121 and the second inspection device 122 may communicate with the collation device 123 through a wired or wireless communication network.

The collation device 123 may include a PC device and may be equipped with a general-purpose memory and processor. The collation device 123 may receive inspection data from the first inspection device 121 and the second inspection device 122. According to the embodiment, the collation device 123 may execute intermediate management software for managing the inspection data transmitted from the first inspection device 121 and the second inspection device 122. For example, the collation device 123 may convert a data format of some of the inspection data. The collation device 123 may collate the inspection data transmitted from the first inspection device 121 and the second inspection device 122 and provide the inspection data to the management server 124.

The management server 124 may record and manage the collation data provided from the collation device 123. The management server 124 may store the inspection data in a database. According to the embodiment, the inspection data transmitted from the first inspection device 121 and the second inspection device 122 may include image data and value data, and the management server 124 may separately manage the image data and the value data using different DBs.

The first inspection device 121 may be configured to generate a first inspection image and first inspection values for a result of a first manufacturing process of the battery cell 110. For example, the first inspection device 121 may generate a first inspection image by photographing the result of any one of the detailed manufacturing processes of the battery cell 110, and may derive the first inspection values through image processing of the first inspection image.

The second inspection device 122 may be configured to generate a second inspection image and second inspection values for a result of a second manufacturing process of the battery cell 110. For example, the second inspection device 122 generate a second inspection image by photographing a result of any one of the detailed manufacturing processes of the battery cell 110, and may derive second inspection values through image processing of the second inspection image.

The collating device 123 may be configured to receive the first inspection image, the first inspection values, the second inspection image, and the second inspection values using a plurality of communication schemes. According to the embodiment, a communication scheme that the collating device 123 uses to receive inspection data from the first inspection device 121 may be different from a communication scheme that the collating device 123 uses to receive inspection data from the second inspection device 122. According to the embodiment, a communication scheme that the collating device 123 uses to receive the inspection image may be different from a communication scheme that the collating device 123 uses to receive the inspection value. In this way, a situation where some data is omitted due to traffic overload in the process of collecting inspection data may be prevented.

The management server 124 may be configured to record the first inspection image and the second inspection image in a first database, and record the first inspection values and the second inspection values in a second database. As the inspection image and the inspection value are managed as separate DBs, more efficient data management may be performed. According to the embodiment, the management server 124 may determine whether the battery cell 110 is defective based on the first inspection values and the second inspection values, and may check in which detailed process the defect has occurred.

According to the embodiment, the plurality of communication schemes may include a first communication scheme for receiving the first inspection values, a second communication scheme for receiving the first inspection image, and a third communication scheme for receiving the second inspection image and the second inspection values. The first inspection device 121 may transmit the first inspection values and the first inspection image to the collation device 123 using two different communication schemes. The second inspection device 122 may transmit the second inspection image and the second inspection values to the collation device 123 in a different communication scheme from the communication scheme of the first inspection device 121 in order to avoid traffic overload.

According to the embodiment, the first communication scheme may include a TCP/IP communication scheme, the second communication scheme may include an FTP communication scheme, and the third communication scheme may include an SMB communication scheme. The Transmission Control Protocol/Internet Protocol (TCP/IP) communication scheme may specify detailed rules for communication standards between computers and routing and interconnection of networks. The TCP/IP may be utilized for communication of image data, but transmission of a large amount of image data may cause traffic overload. The File Transfer Protocol (FTP) may refer to a communication protocol for exchanging data between electronic devices. The inspection value may be transmitted using the FTP communication scheme. The Server Message Block (SMB) may refer to a protocol developed to allow Windows systems to share resources such as disks or printers of other systems. In order to prevent data omission due to traffic overload, the third communication scheme may be set to the SMB scheme rather than the TCP/IP or FTP.

According to the embodiment, the first inspection device 121 may be configured to analyze the first inspection image to extract the first inspection values having a first data format, the second inspection device 122 may be configured to analyze the second inspection image to extract the second inspection values having a second data format, and the second data format may have a capacity greater than the capacity of the first data format and a readability higher than the readability of the first data format. According to the embodiment, the second inspection device 122 may have higher processing performance than that of the first inspection device 121, and the SMB communication scheme may have higher communication performance than that of the TCP/IP communication scheme. By using these points, the second data format transmitted by the second inspection device 122 through the SMB communication scheme may have a higher capacity and readability than those of the first data format.

According to the embodiment, the first data format may include a CSV format, and the second data format may include a JSON format. The Comma Separated Values (CSV) format may be a low-capacity format that simply separates data contents. The JavaScript Object Notation (JSON) format is a character-based standard format for expressing data structured with a JavaScript object grammar, and may have relatively high identification capability and readability. By distinguishing the format of the inspection data provided by the first inspection device 121 and the second inspection device 122 into the CSV format and the JSON format, more efficient traffic management may be performed.

According to the embodiment, the collation device 123 may be configured to convert the data format of the first inspection values from the first data format to the second data format, and transmit the second inspection values and the first inspection values converted into the second data format to the management server 124. Management of inspection data in the management server 124 may require unification of data formats. Since the first inspection device 121 and the second inspection device 122 use different data formats for data traffic management, the collation device 123 may unify the data formats. Through this architecture, data management in the management server 124 may also proceed smoothly while avoiding data traffic overload.

According to the embodiment, the battery cell 110 may include a cylindrical battery cell, one of the first manufacturing process and the second manufacturing process may include a process of forming an electrode assembly of the cylindrical battery cell, and the other of the first manufacturing process and the second manufacturing process may include a process of sealing the cylindrical electrode assembly in a cylindrical can to form the cylindrical battery cell. According to the embodiment, the detailed processes of the cylindrical battery cell may further include a positive electrode forming process, a negative electrode forming process, a separation film forming process, a lamination process, a stacking process, a winding process, etc. In this case, additional inspection devices may be provided in addition to the first inspection device 121 and the second inspection device 122.

According to the embodiment, the first inspection image may include an image of one of the electrode assembly and the cylindrical can, the second inspection image may include an image of the other of the electrode assembly and the cylindrical can, the first inspection values may include dimension values of the electrode assembly, and the second inspection values may include dimension values of the cylindrical can. For example, when the detailed dimensions of the electrode assembly and/or the cylindrical can are outside a predetermined normal range, this may be determined as a defect. According to the embodiment, the management server 124 may apply a statistical technique to the first inspection values and the second inspection values to determine whether the electrode assembly and/or the cylindrical can are defective.

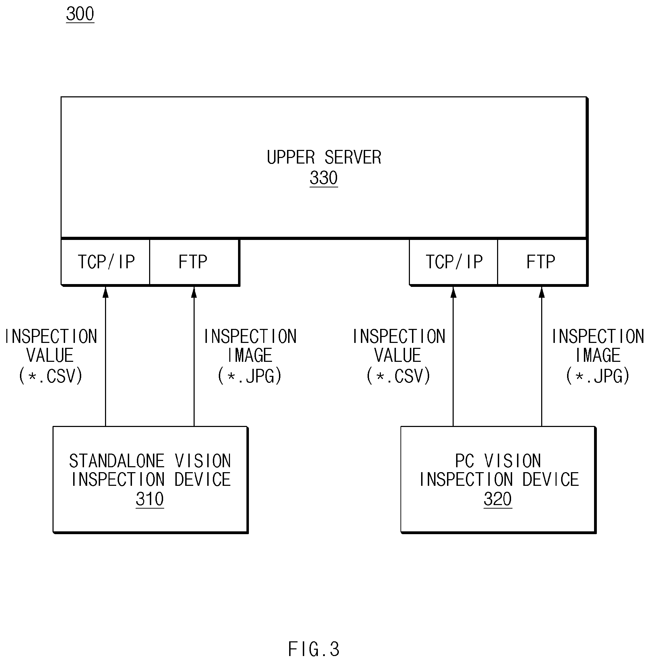

FIG. 3 illustrates a data management method in a manufacturing process of a battery cell according to a prior art.

Referring to FIG. 3, a conventional structure 300 for managing inspection data in the manufacturing process of the battery cell 110 may be illustrated.

In the conventional structure 300, both a standalone vision inspection device 310 and a PC vision inspection device 320 may use the TCP/IP communication scheme and the FTP communication scheme. Specifically, the inspection image for a process result may be transmitted using the FTP communication scheme, and the inspection value for the process result may be transmitted using the TCP/IP communication scheme.

In the case of the conventional structure 300, since the standalone vision inspection device 310 and the PC vision inspection device 320 provide inspection data to an upper server 330 using the same communication scheme, data traffic may become excessively high. In particular, since all the inspection images having relatively high capacity are transmitted using the FTP communication scheme, a situation where some data is lost due to traffic overload may occur.

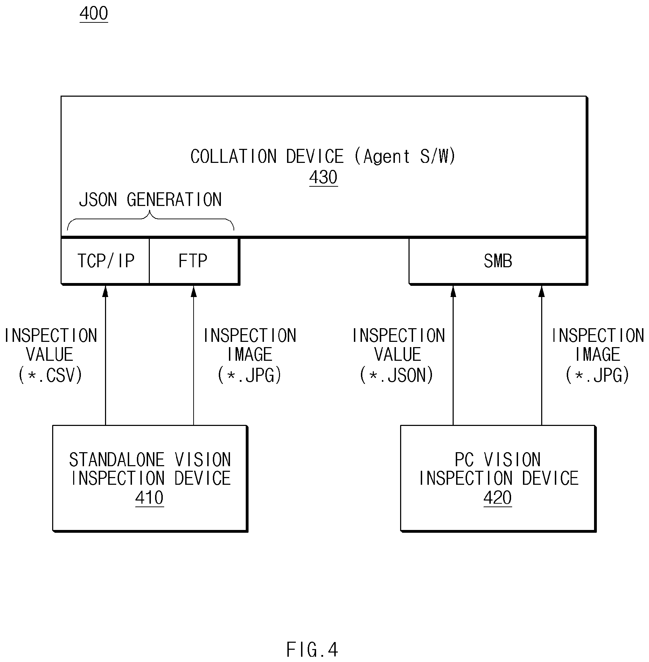

FIG. 4 illustrates communication schemes for collecting inspection data according to some embodiments.

Referring to FIG. 4, a data management system 400 using improved communication schemes for collecting inspection data may be illustrated. The data management system 400 may correspond to the data management system 120.

Unlike the conventional structure 300, in the data management system 400, a PC vision inspection device 420 may transmit an inspection image and inspection value to a collation device 430 using the SMB communication scheme. Therefore, since the standalone vision inspection device 410 and the PC vision inspection device 420 transmit the inspection data in different communication schemes, traffic overload may be prevented and data omission/loss may be prevented.

The inspection images transmitted by the standalone vision inspector 410 and the PC vision inspector 420 may both have a JPG data format. In contrast, the inspection value provided by the standalone vision inspector 410 may have a CSV data format, and the inspection value provided by the PC vision inspector 420 may have the JSON data format. The data format of the inspection value provided by the standalone vision inspector 410 may be converted from the CSV data format to the JSON data format by the collation device 430. The collation device 430 may execute software (Agent S/W) for data collation and management.

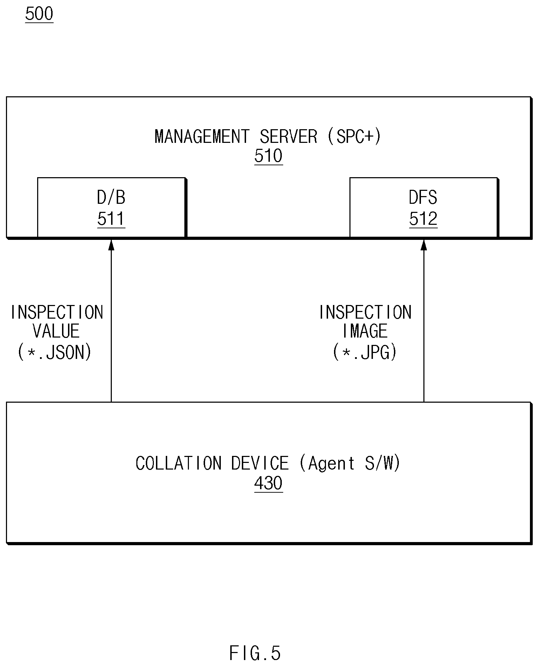

FIG. 5 illustrates a method of recording inspection data collected through communication schemes according to some embodiments.

Referring to FIG. 5, a data management system 500 that manages an inspection value and an inspection image as separate databases may be illustrated. The data management system 500 may correspond to the data management system 120.

In the data management system 500, the collation device 430 may transmit inspection value data and inspection image data to the management server 510. The management server 510 may be a Serviced Privated Cloud Plus (SPC+)-based server. The inspection value data may have the JSON data format, and the inspection image data may have the JPG data format.

The management server 510 may record the inspection value data in a database 511, and may record the inspection image data in a distributed file system (DFS) 512. The DFS 512 may refer to a data storage/management system that supports users or applications to access data files using a network. Since the inspection value data and the inspection image data are managed in different ways, more efficient data management may be possible.

Meanwhile, the process of providing the inspection value data from the collation device 430 to the management server 510 may be performed based on Message Queueing Telemetry Transport (MQTT), Advanced Message Queuing Protocol (AMQP), and SOLACE. SOLACE may be a middleware platform that allows data to be moved in real time regardless of protocols, use cases, patterns, locations, or data types.

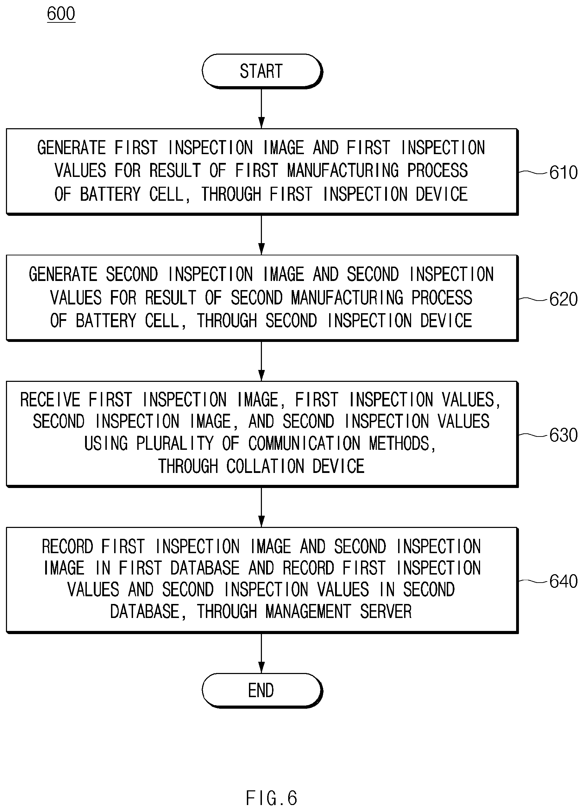

FIG. 6 illustrates steps that constitute a data management method according to some embodiments.

Referring to FIG. 6, the data management method 600 may include steps 610 to 640. However, the present invention is not limited thereto, and some steps may be omitted or other general steps may be added, and the steps of the data management method 600 may be executed in a different order than the illustrated order.

The data management method 600 may be composed of steps that are processed in time series in the data management system 120. Therefore, even if contents are omitted below, the contents described above for the data management system 120 may be equally applied to the data management method 600.

Steps 610 to 640 of the data management method 600 may be performed by the first inspection device 121, the second inspection device 122, the collation device 123, and the management server 124) of the data management system 120.

In step 610, the data management system 120 may generate a first inspection image and first inspection values related to a result of a first manufacturing process of the battery cell, through a first inspection device.

In step 620, the data management system 120 may generate a second inspection image and second inspection values for a result of a second manufacturing process of the battery cell, through a second inspection device.

In step 630, the data management system 120 may receive the first inspection image, the first inspection values, the second inspection image, and the second inspection values using a plurality of communication schemes, through a collation device.

In step 640, the data management system 120 may record the first inspection image and the second inspection image in a first database, and record the first inspection values and the second inspection values in a second database, through a management server.

According to the embodiment, the data management method 600 may be implemented in the form of a computer program stored in a computer-readable storage medium. That is, the computer program may include instructions for implementing the data management method 600, and the instructions of the program may be stored in the computer-readable storage medium. The computer program may include a mobile application.

According to the embodiment, the computer-readable storage medium may include magnetic media such as hard disks, floppy disks, and magnetic tapes, optical media such as CD-ROMs, DVDs, magneto-optical media such as floptical disks, and hardware devices specifically configured to store and execute computer program instructions such as ROMs, RAMs, flash memory, etc. The computer program instructions may include machine language codes generated by a compiler and high-level language codes executable by a computer using an interpreter, etc.

The terms "include," "configure," or "have" described above, unless specifically stated to the contrary, mean that the corresponding component may be included, and therefore should be interpreted as further including other components rather than excluding other components. All terms including technical or scientific terms have the same meaning as commonly understood by a person skilled in the art to which the embodiments disclosed in this document belong, unless otherwise defined. Terms commonly used, such as terms defined in the dictionary, should be interpreted as being consistent with the contextual meaning of the relevant technology, and should not be interpreted in an idealized or overly formal sense unless clearly defined in this document.

The above description is merely an illustrative description of the technical idea disclosed in this document, and a person skilled in the art to which the embodiments disclosed in this document belong may make various modifications and variations there to without departing from the essential characteristics of the embodiments disclosed in this document. Therefore, the embodiments disclosed in this document are not intended to limit the technical idea of the embodiments disclosed in this document, but rather to explain it, and the scope of the technical idea disclosed in this document is not limited by these embodiments. The scope of protection of the technical idea disclosed in this document should be interpreted by the claims below, and all technical ideas with in the equivalent scope should be interpreted as being included in the scope of the rights of this document.

### [Description of symbols]

100: data collection system 110: battery cell
120: data management system 130: database
121: first inspection device 122: second inspection device
123: collation device 124: management server
600: data management method

## Claims

1. A data management system comprising:
a first inspection device configured to generate a first inspection image and a first inspection value related to a result of a first manufacturing process of a battery cell;
a second inspection device configured to generate a second inspection image and a second inspection value related to a result of a second manufacturing process of the battery cell;
a collation device configured to receive the first inspection image, the first inspection value, the second inspection image, and the second inspection value using a plurality of communication schemes; and
a management server configured to record the first inspection image and the second inspection image transmitted from the collation device separately from the first inspection value and the second inspection value transmitted from the collation device.

2. The data management system of claim 1, wherein the plurality of communication schemes include a first communication scheme for receiving the first inspection value, a second communication scheme for receiving the first inspection image, and a third communication scheme for receiving the second inspection image and the second inspection value.

3. The data management system of claim 2, wherein the first communication scheme includes a TCP/IP communication scheme, the second communication scheme includes an FTP communication scheme, and the third communication scheme includes an SMB communication scheme.

4. The data management system of claim 1, wherein the first inspection device is configured to analyze the first inspection image to extract the first inspection value having a first data format,
the second inspection device is configured to analyze the second inspection image to extract the second inspection value having a second data format, and
the second data format has a capacity greater than the capacity of the first data format and a readability higher than the readability of the first data format.

5. The data management system of claim 4, wherein the first data format includes a CSV format, and the second data format includes a JSON format.

6. The data management system of claim 4, wherein the collation device is configured to convert a data format of the first inspection value from the first data format to the second data format, and
transmit the second inspection value and the first inspection value converted into the second data format to the management server.

7. The data management system of claim 1, wherein the battery cell includes a cylindrical battery cell,
one of the first manufacturing process and the second manufacturing process includes a process of forming an electrode assembly of the cylindrical battery cell, and
the other of the first manufacturing process and the second manufacturing process includes a process of sealing the cylindrical electrode assembly in a cylindrical can to form the cylindrical battery cell.

8. The data management system of claim 7, wherein the first inspection image includes an image of one of the electrode assembly and the cylindrical can, the second inspection image includes an image of the other of the electrode assembly and the cylindrical can,
the first inspection value includes dimensional values of the electrode assembly, and the second inspection value includes dimensional values of the cylindrical can.

9. A data management method comprising:
generating, through a first inspection device, a first inspection image and a first inspection value related to a result of a first manufacturing process of a battery cell;
generating, through a second inspection device, a second inspection image and a second inspection value related to a result of a second manufacturing process of the battery cell;
receiving, through a collating device, the first inspection image, the first inspection value, the second inspection image, and the second inspection value using a plurality of communication schemes; and
recording, through a management server, the first inspection image and the second inspection image transmitted from the collation device separately from the first inspection value and the second inspection value transmitted from the collation device.

10. The data management method of claim 9, wherein the plurality of communication schemes include a first communication scheme for receiving the first inspection value, a second communication scheme for receiving the first inspection image, and a third communication scheme for receiving the second inspection image and the second inspection value.

11. The data management method of claim 10, wherein the first communication scheme includes a TCP/IP communication scheme, the second communication scheme includes an FTP communication scheme, and the third communication scheme includes an SMB communication scheme.

12. The data management method of claim 9, wherein the generating of the first inspection value includes analyzing the first inspection image to extract the first inspection value having a first data format,
the generating of the second inspection value includes analyzing the second inspection image to extract the second inspection value having a second data format, and
the second data format has a capacity greater than the capacity of the first data format and a readability higher than the readability of the first data format.

13. The data management method of claim 12, wherein the first data format includes a CSV format, and the second data format includes a JSON format.

14. The data management method of claim 12, further comprising:
converting, through the collation device, a data format of the first inspection value from the first data format to the second data format; and
transmitting, through the collation device, the second inspection value and the first inspection value converted into the second data format to the management server.

15. The data management method of claim 9, wherein the battery cell includes a cylindrical battery cell,
one of the first manufacturing process and the second manufacturing process includes a process of forming an electrode assembly of the cylindrical battery cell, and
the other of the first manufacturing process and the second manufacturing process includes a process of sealing the cylindrical electrode assembly in a cylindrical can to form the cylindrical battery cell.

16. The data management method of claim 15, wherein the first inspection image includes an image of one of the electrode assembly and the cylindrical can, the second inspection image includes an image of the other of the electrode assembly and the cylindrical can, and
the first inspection value includes dimensional values of the electrode assembly, and the second inspection value includes dimensional values of the cylindrical can.
